# EUROPÄISCHE PATENTSCHRIFT

(11) **EP 1 565 929 B1**
(45) Veröffentlichungstag und Bekanntmachung des Hinweises auf die Patenterteilung: **10.10.2007**
(21) Anmeldenummer: 03769144.1
(22) Anmeldetag: 13.11.2003
(51) Int. Cl.: H01J 37/34, C23C 14/35, C23C 14/54

(54) **VERFAHREN ZUR PLASMABEHANDLUNG VON OBERFLÄCHEN IM VAKUUM**
METHOD FOR THE PLASMA TREATMENT OF SURFACES UNDER VACUUM
PROCEDE DE TRAITMENT PAR PLASMA DE SURFACES SOUS VIDE

(30) Priorität: 29.11.2002 CH 201902
(43) Veröffentlichungstag der Anmeldung: 24.08.2005
(73) Patentinhaber: OC Oerlikon Balzers AG, 9496 Balzers (LI)
(72) Erfinder: KADLEC, Stanislav, CH-9470 Buchs (CH); KÜGLER, Eduard, A-6800 Feldkirch-Tisis (AT); HALTER, Thomas, CH-9466 Sennwald (CH)
(74) Vertreter: Troesch Scheidegger Werner AG
(86) Internationale Anmeldenummer: PCT/CH2003/000744
(87) Internationale Veröffentlichungsnummer: WO 2004/050943

(56) Entgegenhaltungen:
- WO-A-02/103078
- WO-A-20/04036616
- US-A1- 2001 010 255
- US-A1- 2002 162 737
- US-B1- 6 290 825
- US-B1- 6 413 382

## Beschreibung

Die vorliegende Erfindung geht aus von Bedürfnissen, welche sich beim Magnetronsputterbeschichten von Substraten ergeben haben. Es hat sich aber ergeben, dass die gemäss vorliegender Erfindung gefundene Lösung sich für durch Vakuumbehandlungsprozesse behandelte Substratoberflächen generell einsetzen lässt.

### Definition

Wir verstehen im Rahmen der vorliegenden Anmeldung unter einem Vakuumbehandlungsprozess und, entsprechend, dessen Wirkung auf ein Substrat einen Prozess,
a) bei welchem plasmaunterstützt Material von der Substratoberfläche entfernt wird, wie beim reaktiven oder nicht reaktiven Plasmaätzen,
b) Material an der Substratoberfläche verändert wird, wie bei reaktivem plasmaunterstütztem Nachbehandeln, beispielsweise Nachoxydieren des Substratoberflächenmaterials,
c) Material auf die Substratoberfläche aufgebracht wird, sei dies reaktiv oder nicht reaktiv oder mittels plasmaunterstütztem CVD. Wird dabei Material aus der Festphase in die Prozessatmosphäre freigesetzt und direkt oder nach einer Reaktion mit Gas auf der Substratoberfläche abgelegt, so verstehen wir als einen zu betrachtenden Prozess ausschliesslich wenn die Freisetzung des erwähnten Materials aus der Festkörperphase an einer Materialquelle erfolgt, woran die Festphase nur eines einzigen Materials vorhanden ist.

Sind zwei oder mehr Quellen vorhanden mit unterschiedlichen Materialien in Festphase, zur Freisetzung in die Prozessatmosphäre, so wird jeder der Freisetzungsprozesse und, entsprechend der Beschichtungsprozesse der bzw. mit den einzelnen Materialien als ein Vakuumbehandlungsprozess für sich betrachtet. In einem solchen Fall werden gleichzeitig zwei und mehr Behandlungsprozesse durchgeführt.

Bei magnetronsputterbeschichteten Substratoberflächen wird bereits heute eine gute Schichtdickenverteilung erzielt, wenn man diese Verteilung betrachtet jeweils in zur Oberfläche des Substrates senkrechten Schnittebenen. Vergleicht man aber die Schichtdickenverteilungen, die sich in den erwähnten Schnittebenen je als gut bis sehr gut ergeben unter sich - also von Schnittebene zu Schnittebene - dann ergibt sich, nun als Schichtdickenverteilung über die Oberfläche zweidimensional betrachtet, eine unbefriedigende Verteilung. Wenn, beispielsweise an sputterbeschichteten kreisscheibenförmigen Substraten, die Schichtdicke entlang der Substratperipherie aufgenommen wird, ergibt sich eine für viele Anwendungszwecke durchaus ungenügende Verteilung.

Aus der US 6 413 382 ist es bekannt, das zum Magnetronsputterbeschichten eingesetzte Magnetfeld entlang des Targets zu bewegen. Das Target wird mit elektrischer Leistung in Form eines Impulszuges betrieben. Es wird erläutert, dass Magnetfeld-Bewegung und Impulszug nicht synchronisiert sein dürfen. Ziel ist, kleindurchmessrige, tiefe Löcher zu beschichten.

Mit demselben Ziel schlägt die US 6 290 825 vor, mittels computerbasierter Steuerung die DC-Speisung des Targets, den Gaszufluss und die Bias-Legung des Substrates zu steuern. Das Magnetronfeld wird entlang des Targets bewegt.

Aus der EP 1 254 970 entsprechend der US 2002/0162737 derselben Anmelderin wie vorliegende Erfindung ist folgendes bekannt:

Ab einer Magnetronsputteranordnung werden unterschiedliche Materialien in die Prozessatmosphäre freigesetzt. Es bilden Targetteile aus unterschiedlichen Materialien jeweils eine Quelle an welcher das jeweilige Material in die Prozessatmosphäre freigesetzt wird. Die durch die Targetteile gebildeten einzelnen Feststoffquellen werden dabei ab einer gemeinsamen Magnetronanordnung betrieben. Um die jeweiligen Sputterverhältnisse je an den beiden Quellen mit unterschiedlichen Materialien einzustellen, und dies mittels einer einzigen Magnetronanordnung, wird einerseits das Magnetronfeld der Magnetronanordnung über die vorgesehenen Targetteile bewegt, somit auch relativ zum Substrat, und es wird Targetteilmaterial-spezifisch mit der Magnetfeldbewegung über die beiden Quellen auch die Sputterleistung in der Zeit verändert. Damit ist es möglich, den unterschiedlichen Sputtercharakteristiken der beiden Quellen konstruktiv höchst einfach ab einer Magnetronanordnung Rechnung zu tragen.

Aus der WO 02/103078, welche Stand der Technik nach Art. 54(3) EPÜ bildet, ist es bekannt, zum Sputterbeschichten, die Plasmaentladungsleistung zu pulsieren und ggf. die Plasmaentladung mit Hilfe rotierender Magnete mitzuerzeugen.

Aus der WO 2004/036616, welche ebenfalls Stand der Technik nach Art. 54(3) EPÜ bildet und von derselben Anmelderin wie vorliegende Erfindung stammt, ist es bekannt, zum Magnetronsputterbeschichten von Substraten, letztere über der Sputterfläche zu bewegen.

Es ist grundsätzlich Aufgabe der vorliegenden Erfindung, ein Verfahren zur Herstellung eines Substrates mit durch einen Vakuumbehandlungsprozess behandelter Oberfläche vorzuschlagen, bei dem die Oberfläche eine vorgegebene, zweidimensionale Flächenverteilung des Behandlungsresultates hat. Die gemäss vorliegender Erfindung gefundene Lösung ergibt sich durch das Verfahren gemäss Anspruch 1.

Es wird z.B. für das Erzielen einer vorgegebenen homogenen Flächenverteilung des Behandlungsresultates, nicht wie man erwarten könnte, eine möglichst homogen dichteverteilte Plasmaentladung angestrebt, sondern eine Plasmaentladung, die örtlich inhomogen ist, d.h. deutlich Bereiche mit gegenüber anderen Bereichen erhöhter Plasmadichte aufweist. Durch gezielte Einstellung der Relativbewegung der inhomogenen Dichteverteilung und der Leistungsvariation wird an der Substratoberfläche die Flächenverteilung des Behandlungsresultates eingestellt.

Beide Grössen, nämlich die erwähnte Bewegung und die erwähnte zeitliche Änderung, werden somit als einzustellende unabhängige Grössen bzw. Variablen der davon abhängigen Funktion "Behandlungsresultat-Verteilung" eingesetzt.

Es werden die vorgegebenen Relativbewegung sowie die vorgegebenen zeitliche Änderung je periodisch erstellt und ihre Abhängigkeit durch Synchronisation erstellt. Dabei ist darauf hinzuweisen, dass es im allgemeinen nicht erforderlich ist, die jeweils erstellten Periodizitäten gleich auszubilden. Es können die Perioden der erwähnten zeitlichen Änderung und der erwähnten Relativbewegung durchaus unterschiedlich sein, und zwar sowohl so, dass die eine Periode ein ganzzahliges Vielfaches der anderen ist, oder so, dass die Perioden in einem nicht-ganzzahligen Verhältnis zueinander stehen.

In einer Ausführungsvariante des erfindungsgemässen Verfahrens ist das Behandlungsresultat eine Beschichtung der erwähnten Oberflächen. Dabei kann aber das Behandlungsresultat auch Ätzen der Behandlungsoberfläche sein, beides, Beschichten oder Ätzen, reaktiv oder nicht reaktiv.

Unter Stationärhalten des Substrates, wird das Erstellen der vorgegebenen Bewegung durch eine vorgegebene Bewegung der inhomogenen Dichteverteilung bezüglich des Vakuumrezipienten erstellt.

In einer bevorzugten Ausführungsvariante wird die Plasmaentladung mit mindestens einem Bereich mit einem überragenden Dichtemaximum erstellt.

In einer weiteren bevorzugten Ausführungsform des erfindungsgemässen Herstellungsverfahrens wird die inhomogene Dichteverteilung mittels eines Magnetfeldes mindestens miterzeugt.

Damit ist nun gemäss einer besonders bevorzugten Ausführungsform eine einfache Möglichkeit geschaffen, die Relativbewegung der inhomogenen Plasmadichteverteilung zu realisieren, nämlich dadurch, dass die Magnetfeldverteilung, ebenfalls inhomogen, im Rezipienten, worin die Entladung erstellt wird, bewegt wird.

Die Plasmaentladung wird mittels DC, AC, DC und überlagertem AC oder mittels Hf erzeugt. Analog kann ggf. das Substrat mittels DC, AC, DC und überlagertem AC oder Hf auf Bias gelegt werden, und es wird dann, bevorzugterweise zusätzlich zur Variation des die Plasmaentladung betreibenden elektrischen Signals, dieses Bias-Signal vorgegeben zeitlich geändert. Wenn wir im vorliegenden Zusammenhang von einer zeitlichen Änderung eines AC-Signals sprechen, dann ist dessen Winkel- oder Amplituden-Änderung, also dessen Modulation angesprochen.

In einer höchst bevorzugten Ausführungsform des erfindungsgemässen Verfahrens wird der Vakuumbehandlungsprozess als Magnetronsputterprozess ausgebildet, und es wird die vorgegebene Relativbewegung mindestens auch durch eine vorgegebene Bewegung des Magnetron-Tunnelfeldes bezüglich einer Targetsputterfläche realisiert.

Es ist bekannt, dass beim Magnetronsputtern, über der Sputterfläche des Targets, ein Magnetfeld erzeugt wird, welches ein oder mehrere tunnelförmige Feldlinienmuster bildet mit Feldlinien, welche aus der Sputterfläche austreten, in einem Abschnitt im wesentlichen parallel zur Targetfläche verlaufen, um dann wieder in die Sputterfläche einzutreten. Konzentriert im Bereich der Feldlininen, in denen sie parallel zur Sputterfläche verlaufen, entsteht durch bekannte Effekte, Elektronenfallen-Effekt, ein schlauchförmiger Bereich erhöhter Plasmadichte. Es ist in diesen Bereichen erhöhter Plasmadichte, in denen die Sputterfläche vermehrt erodiert wird, was zu den im Zusammenhang mit Magnetronsputtern bekannten Erosionsgraben führt. Um dabei insbesondere das Targetmaterial besser zu nutzen, ist es, vornehmlich durch Vorsehen bewegter Magnetanordnungen unterhalb des Targets, bekannt, das Feldlinienmuster während des Sputterbeschichtens entlang der Sputterfläche zu bewegen.

Daraus ist ersichtlich, dass sich Magnetronsputtern ausgezeichnet dafür eignet, gemäss vorliegendem Verfahren vorzugehen, weil dort bereits die Mittel vorhanden sind, eine inhomogene Plasmadichteverteilung bezüglich eines Substrates zu bewegen.

Somit wird, grundsätzlich bevorzugt, die Relativbewegung der örtlich inhomogenen Dichteverteilung des Plasmas bezüglich des Substrates realisiert durch die mechanische Bewegung einer magnetfelderzeugenden Anordnung ausserhalb und/oder innerhalb des Vakuumrezipienten.

Solche Anordnungen werden realisiert, z.B. mit Elektromagneten, Spulenanordnungen, so z.B. Helmholtz-Spulen, Ablenkspulen, bei Magnetrons mit Magnetanordnungen unter dem Target die rotieren oder in gegebenen x- und y-Bewegungen, linear und in gegenseitiger Abhängigkeit, bewegt werden. Anstelle einer mechanischen Bewegung kann das Magnetfeld aber auch elektrisch bewegt werden, durch gesteuerte, zeitvariable Ansteuerung fest eingebauter Spulenanordnungen. Mechanische Bewegung von Magnetfeld-Erzeugern und elektrische, zeitvariable Ansteuerung von Spulen, die dabei zusätzlich auch mechanisch bewegt werden können, können durchaus kombiniert werden.

In einer weiteren bevorzugten Ausführungsform des erfindungsgemässen Verfahrens wird mit Hilfe der Entladung ein Feststoff in die Behandlungsatmosphäre freigesetzt. Es wird weiter in die genannte Atmosphäre ein Reaktivgas eingelassen.

Die Verteilung des Verbindungsverhältnisses zwischen Feststoff und Komponenten des Reaktivgases auf der Oberfläche wird als Behandlungsresultat eingestellt.

Wird beispielsweise als Feststoff ein Metall in die Behandlungsatmosphäre mit dem Reaktivgas freigesetzt, so wird die Verteilung der Stöchiometrie des an der Oberfläche abgesetzten Verbindungsmaterials, im Sinne des zu erzielenden Behandlungsresultates, eingestellt.

In einer weiteren bevorzugten Ausführungsform des erfindungsgemässen Verfahrens wird, vor Behandlungsende, ein Behandlungs-Zwischenresultat gemessen, mit einem Soll-Behandlungszwischenresultat verglichen, und es wird in Funktion des Vergleichsresultates die vorgegebene Relativbewegung und/oder die zeitliche Änderung nachgestellt. Dabei erfolgt die erwähnte Messung, weiter bevorzugt, ohne Vakuumunterbrechung. Das Substrat kann dabei sehr wohl von einem Vakuum ins andere transportiert werden, beispielsweise von Behandlungsatmosphäre in eine Messatmosphäre, oder es wird die erwähnte Messung, wie weiter bevorzugt, in situ während der Substratbehandlung, also in der Behandlungsprozessatmosphäre, vorgenommen. Dann wird, weiter bevorzugt, das Messresultat als gemessene Regelgrösse einem Regelkreis zugeführt, welcher die vorgegebene Relativbewegung und/oder zeitliche Änderung als Stellgrösse für eine Behandlungsresultats-Regelung stellt.

Das vorgeschlagene Verfahren eignet sich insbesondere für die Herstellung von auf der Basis akustischer Oberflächenwellen arbeitenden oder von auf der Basis von "bulk acoustic waves" arbeitenden Komponenten.

Die Erfindung wird anschliessend beispielsweise anhand von Figuren erläutert. Es zeigen:
- Fig. 1: schematisch, eine erfindungsgemässe, zur Durchführung des erfindungsgemässen Herstellungsverfahrens eingesetzte Behandlungskammer, auch zur prinzipiellen Erläuterung der vorliegenden Erfindung;
- Fig. 2: in Aufsicht, weiterhin schematisch, ein gemäss vorliegender Erfindung in einem inhomogen dichteverteilten Plasma bewegtes Substrat;
- Fig. 3: beispielsweise Bewegungsverläufe zwischen einem Substrat und einer inhomogenen Dichteverteilung eines Plasmas sowie, beispielsweise, ein zeitlicher Verlauf der das Plasma speisenden elektrischen Leistung;
- Fig. 4: vereinfacht, im Längsschnitt, eine Behandlungskammer, woran das erfindungsgemässe Verfahren mittels einer Magnetronsputterquelle realisiert ist;
- Fig. 5: schematisch, die in situ-Erfassung des während der Substratbehandlung entstehenden Behandlungsresultates und Führung des Verfahrens gemäss vorliegender Erfindung als geregeltes Verfahren;
- Fig. 6: in Aufsicht, die Konstellation der Magnetron-Magnetanordnung, wie sie an der Anlage gemäss Fig. 4 für die nachfolgend gezeigten Versuche eingesetzt wurde;
- Fig. 7 bis 13:: erzielte Behandlungsresultats-Verteilungen in Form von Schichtdidkenverteilungen, bei verschiedenen Einstellungen der erfindungsgemäss eingesetzten Einstellgrössen;
- Fig. 14: schematische Darstellung der erfindungsgemäss erzielten Schichtverkippung.

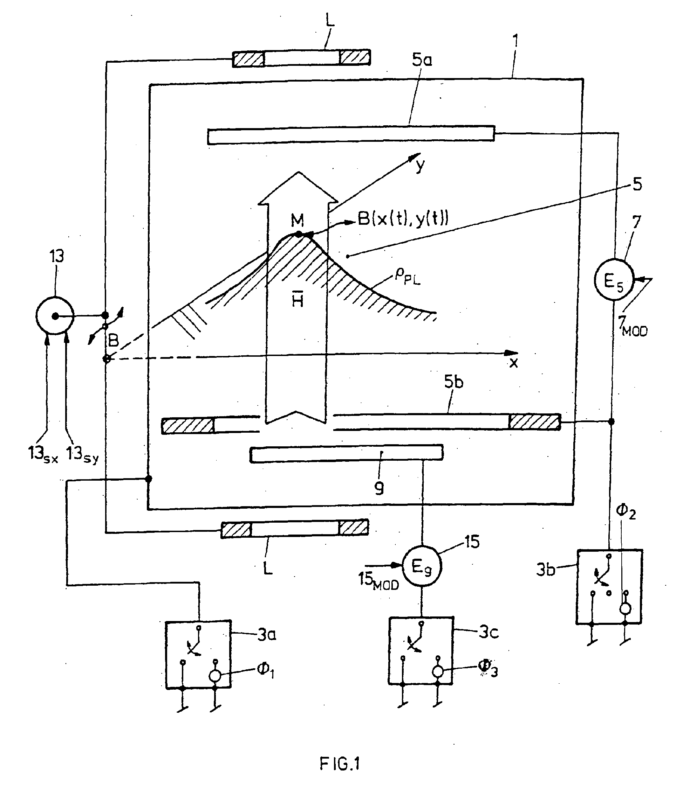

Anhand von Fig. 1 soll das Grundprinzip des erfindungsgemässen Herstellungsverfahrens sowie der erfindungsgemässen Behandlungskammer vorgestellt werden. In einem Vakuumrezipienten 1, welcher, wie mit dem Auswahlschalter 3a schematisch dargestellt, auf Masse oder ggf. auf ein anderes Bezugspotential φ₁ elektrisch gelegt ist, ist eine Plasmaentladungsstrecke 5 vorgesehen, wie schematisch dargestellt mit einer Elektrode 5a und einer Elektrode 5b. Die Plasmaentladungsstrecke 5 wird mittels eines Generators 7 elektrisch betrieben, bei welchem es sich um einen DC-, einen AC-, einen DC+AC- oder einen Hf-Generator handeln kann. Selbstverständlich sind entsprechend der vorgesehenen Plasmaentladungsgattung auch die Elektroden 5a, 5b, wie dem Fachmann geläufig, gestaltet.

Wie wiederum ein Auswahlschalter 3b schematisiert, kann der Generator 7 je nach Einsatzzweck elektrisch fliegend, auf Massepotential oder auf ein anderes Bezugspotential φ₂ gelegt sein, welches selbstverständlich auch gleich φ₁ gewählt sein kann.

Der Generator 7 hat einen Modulationseingang 7_{MOD}, woran grundsätzlich das die Strecke 5 speisende elektrische Signal E₅ in der Zeit moduliert werden kann bezüglich DC-Wert und/oder Phase und/oder Amplitude und/oder Zeitverlauf.

Die Plasmaentladungsstrecke 5 ist so ausgebildet, dass sie ein inhomogen dichteverteiltes Plasma erzeugt. Eine zweidimensionale inhomogene Plasmadichteverteilung ist in Fig. 1 bei ρ_{PL} dargestellt, beispielsweise mit einem Dichtemaximum M. Die Plasmadichteverteilung ρ_{PL} kann mit Bezug auf ein Substrat 9 mit einer vorgegebenen Bewegung bewegt werden.

Wiewohl dem Fachmann durchaus auch andere Massnahmen bekannt sind, lokal die Plasmadichte zu erhöhen (z.B. bewegter Plasmastrahl) und damit eine inhomogene Plasmadichteverteilung zu schaffen und zu bewegen, ist in Fig. 1 die Möglichkeit dargestellt, dies mittels Magnetfeld zu realisieren. Hierzu wird im Plasma lokal ein Magnetfeld *H̅* erzeugt, beispielsweise mit einer gesteuert bewegten Spulenanordnung. Die Magnetfeldverteilung in der Entladungsstrecke 5 wird durch mechanische Bewegung der Spulenanordnung L, wie mit einem motorischen Antrieb 13 in Fig. 1 schematisiert, bewegt. Die vom Antrieb 13 der Spulenanordnung L auferlegte Bewegung wird an Steuereingängen 13_{SX}, 13_{SY}, jeweils in x- und y-Richtung, des Antriebs 13 vorgegben. Wesentlich ist im Rahmen der vorliegenden Erfindung, dass mit Bezug auf Substratträger bzw. das Substrat 9 die inhomogene Dichteverteilung ρ_{PL} des Plasmas einer vorgegebenen Bewegung auferlegt wird, was gemäss Fig. 1 durch entsprechend vorgegebene Bewegung einer Magnetfeldverteilung in der Plasmastrecke 5 erfolgt.

Anstelle oder hinzukommend zur Modulation des elektrischen Speisesignals E₅ der Plasmaentladungsstrecke 5 kann der Substratträger bzw. das Substrat 9 mit Hilfe eines Signalgenerators 15 auf Bias gelegt werden, grundsätzlich wiederum auf DC, AC, AC+DC oder Hf. Dies, wie mit einem weiteren Auswahlschalter 3c schematisiert, bezüglich Massepotential oder bezüglich eines weiteren Bezugspotentials φ₃.

Falls diese Biaslegung des Substratträgers 9 vorgesehen ist, hat der Generator 15 vorzugsweise auch einen Modulationseingang 15_{MOD}, woran das Biassignal, wie bereits bezüglich des Signals E₅ zum Betrieb der Plasmaentladungsstrecke 5 erläutert wurde, in der Zeit moduliert bzw. geändert wird.

Es bezeichnen:
E₅: das elektrische Speisesignal (Strom und/oder Spannung) der Plasmaentladung
B(x(t), y(t)) : die x/y-Bewegung der Verteilung ρ_{PL} bezüglich dem Substrat, abgekürzt auch mit B bezeichnet
E₉: das Substrat-Bias-Signal

Sind E₅, B bzw. E₉, B periodische Signale, so wird, entsprechend an 7_{MOD}, 13_{S} bzw. 5_{MOD}, 13_{S}, eingestellt, nebst den jeweiligen Amplituden, den zeitlichen Signalverläufen (Impuls, Trapez, Dreieck, Sinus etc.), daran auch die Signalperiode bzw. -frequenz eingestellt.

Wie anhand von Fig. 1 gezeigt wurde, kann die Relativbewegung der inhomogenen Plasmadichteverteilung ρ_{PL} bezüglich der zu behandelnden Substratoberfläche durch Verschiebung bzw. Bewegung der Plasmadichteverteilung ρ_{PL} bezüglich Rezipient 1 erfolgen. Wesentlich ist, dass, über die Behandlungszeit betrachtet, und nach einem mit der erwähnten Bewegung einstellbaren Muster, die Substratoberfläche sequentiell mit der inhomogenen Plasmadichteverteilung ρ_{PL} überstrichen wird. Gleichzeitig erfolgt, wie erwähnt wurde, die Variation der Entladespannung bzw. des Entladestromes und/oder, falls vorgesehen, der Biasspannung am Substrat über der Zeit.

Bezüglich der Bewegung der inhomogenen Plasmadichteverteilung ρ_{PL} bezüglich des Substrates muss darauf hingewiesen werden, dass diese Bewegung zweidimensional (x, y) ist.

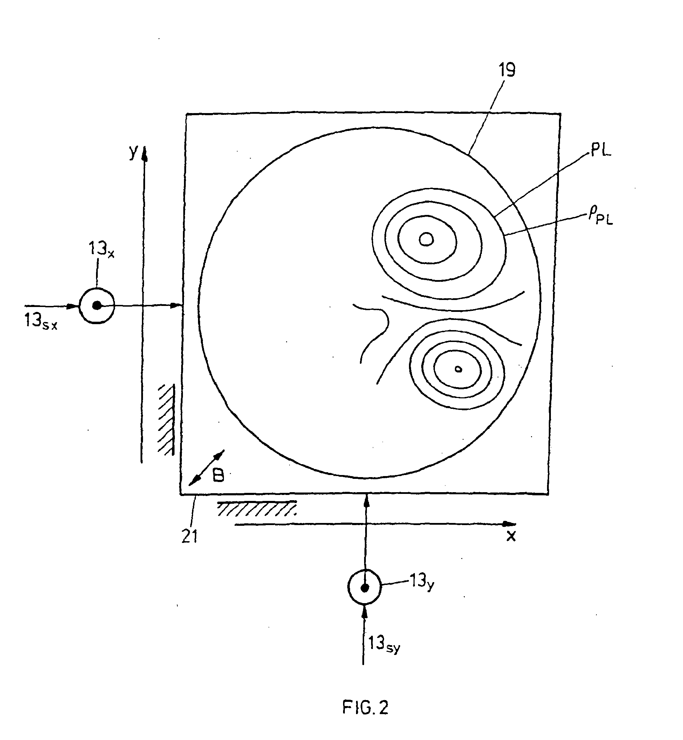

In Fig. 2 ist weiterhin stark schematisiert, ein kreisscheibenförmiges Substrat 19 auf einem Substratträger 21 in Aufsicht dargestellt. Eine Prozesskammer gemäss 1 von Fig. 1 ist in dieser Darstellung nicht dargestellt. An der hier auch nicht gezeichneten Plasmaentladungsstrecke wird im Vakuumrezipienten stationär eine Plasmaentladung PL mit, wie in Fig. 2 gezeigt, im wesentlichen zweidimensional inhomogener Plasmadichteverteilung ρ_{PL} erstellt. Mittels Antrieben 13ₓ und 13y wird, mit dem Substratträger 21, das Substrat 19 relativ zur kammerstationären, inhomogenen Dichteverteilung ρ_{PL} verschoben. Mit dem Steuersignal 13ₛₓ wird die x-Bewegung des Substratträgers, mit dem Steuersignal 13_{sy} die y-Bewegung angesteuert.

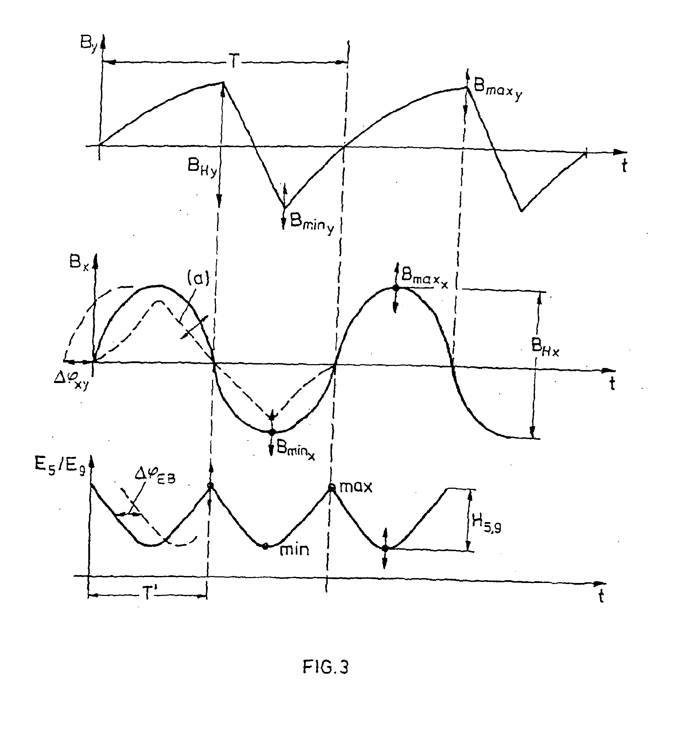

In Fig. 3 sind, beispielsweise, über der Zeit t die Verläufe der Bewegung B(x,y) sowie von E_{S} bzw. E₉ dargestellt. Die in Fig. 3 dargestellten Bewegungen Bₓ und B_{y} weisen gleiche Perioden T auf, während das Signal E₅ bzw. E₉ eine Periode T' = ½ T hat. Bei den periodischen Signalen wird die gegenseitige Phasenlage eingestellt, wie die Phasenlage Δϕ_{xy} zwischen Bewegung in x-Richtung und Bewegung in y-Richtung, sowie die Phasenlage zwischen E₅ und, z.B. Bₓ, Δϕ_{EB}. Dabei können die Perioden der zwei bzw. drei Signale um ganzzahlige oder nichtganzzahlige, rationale Faktoren voneinander verschieden sein. Es wird, bevorzugterweise, die Phasenverschiebung Δϕ_{xy}, Δϕ_{EB} eingestellt und es sind die Signale im Sinne einer Phasenverriegelung synchronisiert. Im weiteren werden bevorzugterweise für Bₓ, Maximal- und Minimalwerte Bₘₐₓₓ, Bₘᵢₙₓ oder der Bewegungshub B_{Hx} eingestellt, desgleichen, wie in Fig. 3 dargestellt, für die y-Bewegungskomponente sowie E₅ bzw. E₉. Weiter bevorzugt werden die Zeitverläufe der jeweiligen Signale, wie in Fig. 3 am Verlauf von Bₓ bei (a) dargestellt, eingestellt.

Durch entsprechende Wahl insbesondere der erwähnten Grössen und ihre gegenseitige Abstimmung wird erfindungsgemäss an der plasmabehandelten Substratoberfläche die Flächenverteilung des Bearbeitungsresultates eingestellt.

Mit Vorgehensweisen wie anhand von Fig. 1 und 2 dargestellt, können, als Bearbeitungsresultat, Ätzprofile an der Substratoberfläche eingestellt werden, nicht reaktiver oder reaktiver Ätzverfahren. Auch bei plasmaunterstützten chemischen Dampfabscheidungsverfahren (PECVD) kann mit der dargestellten Vorgehensweise das Flächenprofil der auf der betrachteten Substratoberfläche abgelegten Schichten eingestellt werden. Wird bei reaktiven Verfahren, oder auch bei den PEVCD-Verfahren, ein konstanter Reaktivgas-Partialdruck über den Substratoberfläche eingestellt, so ermöglicht das dargestellte Vorgehen, die resultierende flächige Verteilung der abgelegten Schicht gezielt auszulegen, bezüglich Schichtdicke bzw. Stöchiometrieverhältnisse.

Wie erläutert wurde, ist es mit Wesen der vorliegenden Erfindung, bezüglich einer zu behandelnden Substratoberfläche, eine inhomogene Plasmadichteverteilung ρ_{PL} zu bewegen.

Ausgesprochen inhomogene Plasmadichteverteilungen werden beim Magnetronsputtern eingesetzt, indem dort entlang der tunnelförmigen Magnetfeldschleifen Bereiche hoher Plasmadichten über den Targetsputterflächen erzeugt werden. Wie eingangs erläutert, ist es bei Magnetronsputtern durchaus üblich, insbesondere aus Gründen der Erhöhung der Targetmaterialnutzung, z.B. durch Vorsehen unter dem Target bewegter Magnetanordnungen, die Tunnelfeldbereiche und damit die inhomogene Plasmadichteverteilung zu bewegen. Mithin bietet sich Magnetronsputtern geradezu ideal an, um nach dem erfindungsgemässen Vorgehen eingesetzt zu werden. Dabei kann die Magnetronentladung mit DC, mit AC, mit überlagertem AC+DC oder mit Hf betrieben werden. Weiter kann es sich um reaktives Magnetronsputtern oder nicht reaktives Magnetronsputtern handeln.

Wie eingangs erwähnt wurde, wurde denn auch die vorliegende Erfindung auf Bedürfnisse hin erarbeitet, welche aus der Magnetronsputterbeschichtungstechnik resultieren und, wie anhand der Fig. 1 - 3 erläutert wurde, ganz grundsätzlich auf die Einstellung der Wirkungs- bzw. Resultatsverteilung einer Plasmabehandlung entlang einer Substratoberfläche erweitert.

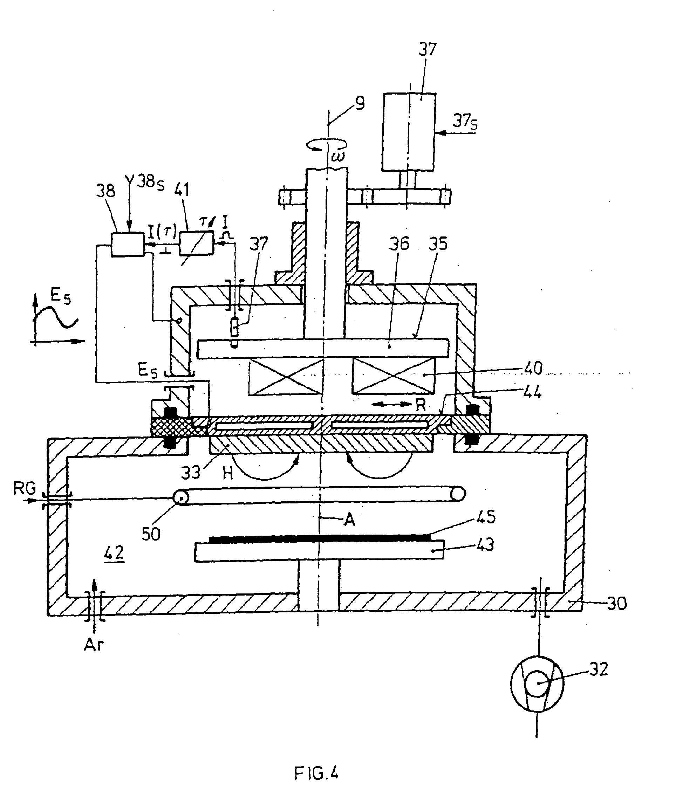

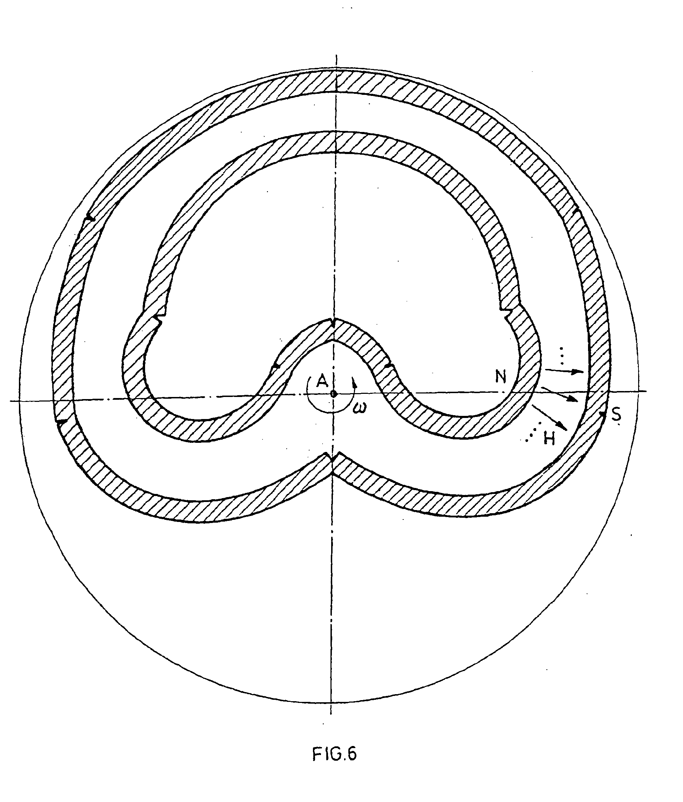

In Fig. 4 ist eine Vakuumbehandlungskammer in Form einer Magnetronsputterbeschichtungskammer dargestellt, woran das erfindungsgemässe Herstellungsverfahren durchgeführt wird. Eine Vakuumkammer 30 ist über eine Pumpvorrichtung 32 evakuierbar. Auf einer Targetrückplatte 44 ist ein Target 33 aus zu sputterndem Material angebracht. Hinter der Tartetrückplatte 44, ausserhalb der Vakuumkammer 30, befindet sind ein Magnetsystem 35. Dieses umfasst beispielsweise einen um eine Zentralachse A getrieben drehbeweglichen Magnetträgerteller 36 mit diesbezüglich asymmetrisch angeordneter, in Aufsicht beispielsweise nierenförmiger - es sei auf Fig. 6 verwiesen - Anordnung von Permanentmagneten 40. Gegebenenfalls können die Magnete 40 der Magnetanordnung getrieben und wie bei R dargestellt zusätzlich zu ihrer Drehbewegung ω um Achse A auch radial getrieben verschieblich sein. Mittels der Magnetanordnung 40 wird, wie schematisch bei H dargestellt, ein ausgesprochen inhomogenes Magnetfeld bezüglich dem Substrat 45 auf dem Substratträger 43 bewegt.

Die Drehbewegung der Magnetanordnung 35, erzeugt durch einen Motor mit Steuereingang 37_{S}, wird mittels einer Detektoranordnung 37 abgetastet. Die Abtastimpulse I der Detektoreinheit 37 werden an einer Einheit 41 einstellbar zeitverzögert, τ; die ausgangsseitigen, zeitverzögerten Impulse I(τ), triggern bzw. synchronisieren das z.B. sinusförmige Signal E₅. Somit wird, rückblickend auf Fig. 3, mit τ Δϕ_{EB} vorgegeben. An einem weiteren Steuereingang am Generator 38, 38_{S} wird der Hub des sinusförmigen Signalanteils von E₅ eingestellt.

Es mündet in die Behandlungskammer 30, wie bei 42 dargestellt, eine Gasleitung für ein Arbeitsgas, vorzugsweise Argon, ein, wobei ggf. über die gleiche Gaszuspeisung, bevorzugterweise aber mittels einer schematisch bei 50 dargestellten Gasbrause, ein Reaktivgas in den Prozessraum eingelassen wird für reaktives Magnetronsputterbeschichten.

Wird über der Oberfläche des Substrates 45 ein mindestens genähert gleich verteilter Partialdruck des Reaktivgases erstellt, so kann durch die Einstellung der Bewegung des inhomogen dichteverteilten Magnetronplasmas und die zeitliche Führung der Plasmaentladungsleistung E₅, entlang der Substratoberfläche, die Verteilung der Zusammensetzung der Schicht eingestellt werden oder die Schichtdickenverteilung.

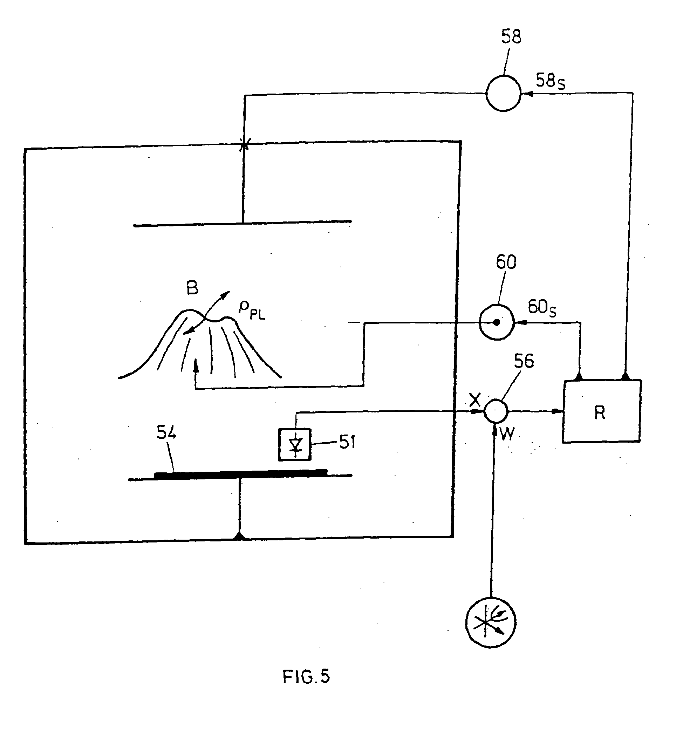

Gemäss Fig. 5 wird während der Durchführung des erfindungsgemässen Verfahrens in situ mittels einer Messeinrichtung 51, beispielsweise mittels Ellipsometrie, elektrische Widerstandsmessung, Profilmessung der Oberfläche mittels optischer Reflexionsmethoden etc., mit einem stationären ggf. bewegten Messfühler die Verteilung des Behandlungsresultates an der Oberfläche des Substrates 54 erfasst. Das Messresultat x wird mit einer vorgegebenen Resultatsverteilung W verglichen, an einer Differenzeinheit 56. Dabei erfolgt der Vergleich der momentan durch Messung ermittelten Resultatverteilung mit einer Soll-Verteilung, welche für die bereits erfolgte Behandlungszeit zweidimensional massgeblich ist. Abweichungen zwischen Ist-(X) und Soll-(W)-Verteilung werden über eine Recheneinheit R als Stellsignale 58ₛ einer Generatoreinheit 58 für die Plasmaentladung und/oder einer Führungseinheit 60 für die Bewegung der inhomogenen Plasmadichteverteilung ρ_{PL} bezüglich der Substratoberfläche zugeführt. Anstelle einer derartigen in situ-Regelung der im Entstehen begriffenen Behandlungswirkung, ist es durchaus möglich, nach vorgegebenen oder vorgebbaren Behandlungszeitabschnitten das Substrat von der Behandlungskammer in eine Messkammer, unter Beibehalt von Vakuumbedingungen, überzuführen, dort als Zwischenresultat das bis anhin erzielte Behandlungsresultat bzw. dessen Verteilung zu erfassen, das Substrat zurück in die Behandlungskammer zu führen und dort mit entsprechend angepassten Grössen bezüglich Bewegung der inhomogenen Plasmadichteverteilung und der Plasmaentladungsleistung E₅ den Prozess weiter zu führen.

Nachfolgend werden Resultate vorgestellt, wie sie bei gemäss vorliegender Erfindung durchgeführten Herstellungsverfahren mit Magnetronsputterbeschichten mittels einer Anlage, wie sie prinzipiell in Fig. 5 dargestellt ist, erzielt wurden.

### Versuchsaufbau:

- Behandlungskammer: CLC 200 BB281100 x
- Vakuumpumpe: Cryo CTI Cryogenics PJ9744445
- Magnetronmagnetsystem:
   MB 300DK ALN02
- DC Power supply: Pinnacle (Firma Advanced Energy), ergänzt mit ad cup 10 kW M/N 3152436-100A
- Schichtdickenregistrierung:
   Spektraler Ellipsometer WVASE M-2000F, Version 3.333
- Substrate: 6" Silizium-Wafer
- Magnetron-Sputterbeschichten ab Aluminiumtarget in Stickstoff enthaltender Atmosphäre mit AIN
- Mittelwert der Entladungsleistung:
   E₅ = 8 kW
- Leistungsmodulationsform:
   Sinus
- Leistungsmodulationsfrequenz:
   5,95 Hz
- Einstellbare Phasenverriegelung der Magnetanordnungs-Drehbewegung ω gemäss Fig. 4 mit der Leistungsmodulation von E₅.
- Einstellbarer Modulationshub von E₅

In Fig. 6 ist, in Aufsicht, das mit konstanter Drehgeschwindigkeit ω angetriebene Magnetsystem der Magnetronanordnung dargestellt.

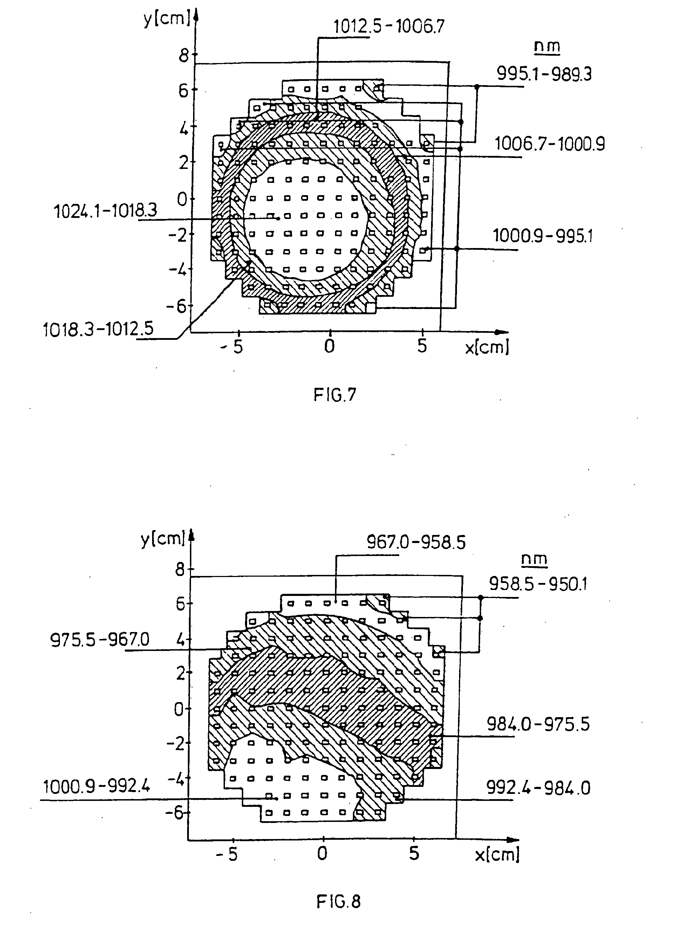

In Fig. 7 ist am 6"-Substrat die Flächenverteilung des Behandlungsresultates, nämlich des reaktiven Magnetronsputterbeschichtens mit der AlN-Schicht, dargestellt, als Referenzbeispiel ohne Modulation der Entladungsleistung E₅.

Mit einem Modulationshub von 5,6 % wurde nun die Plasmaleistung E₅ moduliert bei verriegelter Phase Δϕ_{EB} = 0. Fig. 8 zeigt das Resultat.

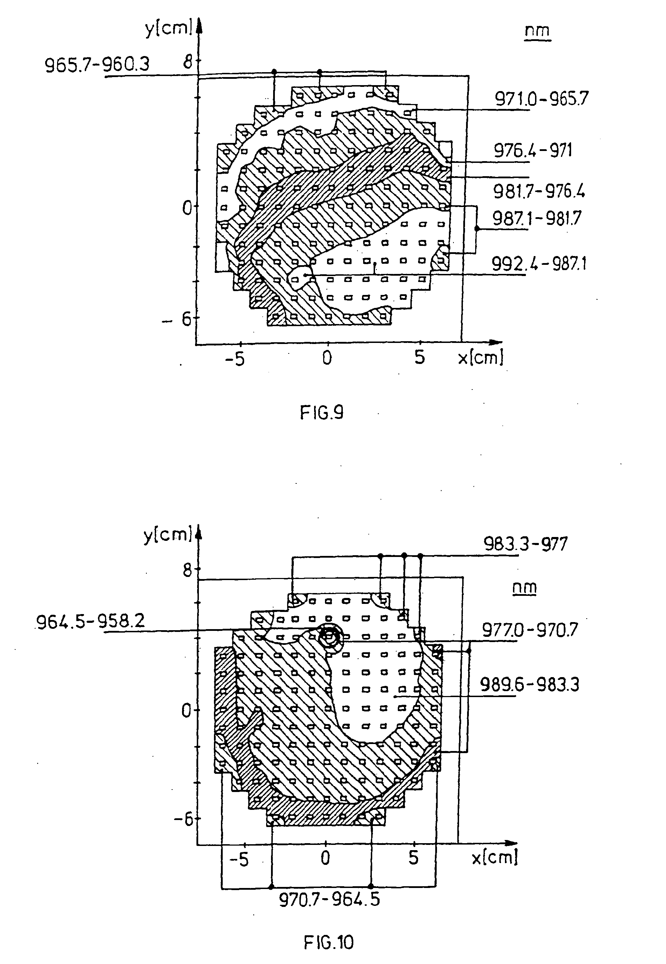

Die Schichtdickenverteilung gemäss Fig. 9 ergab sich weiterhin bei einem Modulationshub der Entladungsleistung E₅ von 5,6 % bei einer verriegelten Phase Δϕ_{EB} von 90°.

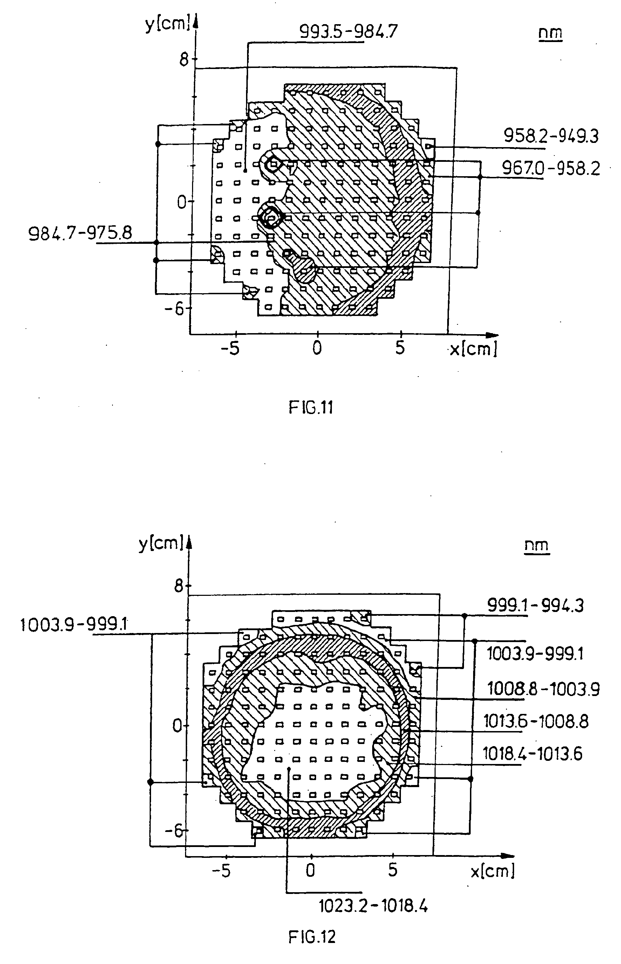

Weiterhin bei Einhalt eines Modulationshubes von 5,6 % und bei weiteren Phasendrehung auf Δϕ_{EB} = 180° ergab sich die Verteilung gemäss Fig. 10. Bei weiterer Erhöhung der Phasendifferenz Δϕ_{EB} auf 270° wurde die Verteilung, wie Fig. 11 zeigt. Weiterhin mit gleichbleibendem Modulationshub wurde schliesslich die Phasenlage auf Δϕ_{EB} = 195° optimiert. Es resultiert die in Fig. 12 dargestellte Verteilung.

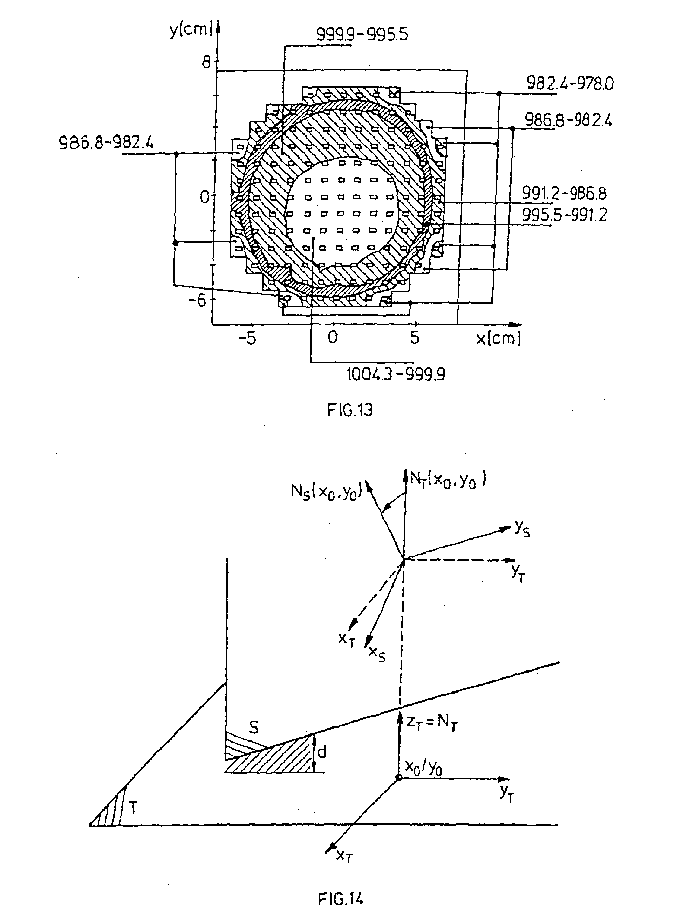

Zum Erhalt der Verteilung gemäss Fig. 13 wurde nun weiter bei gemäss Fig. 12 konstant belassener Phasenlage Δϕ_{EB} = 195°der Modulationshub von 5,6 % auf 8,7 % angehoben.

Aus den Sequenzen erst bei Phasenoptimierung, dann bei Modulationshuboptimierung ist ersichtlich, wie gemäss vorliegender Erfindung durch Einstellung einerseits der Bewegung zwischen inhomogen dichteverteiltem Plasma und der zeitlichen Veränderung des Plasmaentladungs-Speisesignals, eine erwünschte flächige Wirkungsverteilung, hier Verteilung der Schichtdicke, erzielt werden kann, so beispielsweisse gemäss Fig. 13 eine erwünschte azimutal und radial möglichst homogene, d.h. gleichförmig Schichtdickenverteilung.

In Fig. 14 ist aus einem etwas anderem Blickwinkel als bis anhin eine Hauptanwendung der vorliegenden Erfindung schematisch dargestellt. Wie erwähnt wurde, ist eine der erfindungsgemäss erzielten Verteilungen eines Behandlungsresultates die Verteilung einer Schichtdicke. Gemäss Fig. 14 wird auf der Oberfläche T eines planen Substrates, nach dem erfindungsgemässen Verfahren, eine Schicht abgelegt, mit der Oberfläche S und der Verteilung der Dicke d entlang der Oberfläche T. Wird in die plane Oberfläche T des Substrates das Koordinatensystem x_{T}/y_{T} und Z_{T} gelegt, am Ort x_{O}/yₒ so hat die Z-Achse die Richtung der Flächennormalen N_{T} an besagtem Ort. An der Schichtoberfläche S wird nun erfindungsgemäss am selben Ort xₒ/yₒ die Flächennormale N_{S} bezüglich der Richtung der Flächenormalen N_{T} räumlich verkippt, entsprechend dem Koordinatensystem in der Oberfläche S am Ort xₒ/yₒ. Dieser Verkippung der Schichtoberfläche S bezüglich der im wesentlichen planen Substratoberfläche T oder auch, genereller, einer nicht planen Oberfläche T wird als Schichtverkippung bezeichnet. Ein wesentlicher Anwendungsfall der vorliegenden Erfindung ist es die Schichtverkippung räumlich nach vorgegebenem Verhältnis auszulegen und zwar gegebenenfalls entlang der Substratoberfläche T lokal verschieden. Die Schichtverkippung, die erfindungsgemäss angestrebt wird, kann dabei mindestens in Bereichen der Oberfläche T null sein, dann stimmt die Richtung N_{S} mit der Richtung N_{T} überein.

## Patentansprüche

1. Verfahren zur Herstellung eines Substrates mit einer mittels eines Vakuumprozesses behandelten Oberfläche, nämlich durch Beschichten der Substratoberfläche mittels einer einzigen Quelle, von welcher ein einziges Material aus der Festkörperphase plasmaunterstützt in die Prozessatmosphäre freigesetzt wird oder durch plasmaunterstütztes Entfernen von Material von der Substratoberfläche oder durch plasmaunterstütztes Verändern von Material an der Substratoberfläche, bei dem die Oberfläche eine vorgegebene Flächenverteilung des Behandlungsresultates hat, wobei eine Plasmaentladung mit einer örtlich inhomogenen Dichteverteilung erstellt wird, das Substrat der Wirkung der inhomogen dichteverteilten Plasmaentladung ausgesetzt und dabei eine vorgegebene periodische Bewegung der inhomogenen Dichteverteilung bezüglich des Substrates, das bezüglich eines Vakuumrezipienten stationär ist, erstellt wird, bei dem weiter eine vorgegebene periodische zeitliche Änderung der elektrischen Leistung, die die Entladung speist und/oder eines gegebenenfalls vorgesehenen weiteren elektrischen Signals, das das Substrat auf Bias legt, erstellt wird und dass besagte zeitliche Änderung mit der vorgegebenen Bewegung synchronisiert wird und durch Einstellen der Bewegung und der zeitlichen Änderung die vorgegebene Flächenverteilung erstellt wird.

2. Verfahren nach Anspruch 1, **dadurch gekennzeichnet, dass** die Plasmaentladung mit mindestens einem Bereich mit einem überragenden Dichtemaximum erstellt wird.

3. Verfahren nach einem der Ansprüche 1 oder 2, **dadurch gekennzeichnet, dass** man die inhomogene Dichteverteilung mittels eines Magnetfeldes mindestens miterzeugt.

4. Verfahren nach Anspruch 3, **dadurch gekennzeichnet, dass** man die Magnetfeldverteilung örtlich im Rezipienten, worin die Entladung erstellt wird, bewegt.

5. Verfahren nach einem der Ansprüche 1 bis 4, **dadurch gekennzeichnet, dass** man die Plasmaentladung und/oder die Biaslegung mittels DC, AC, DC und überlagertem AC erzeugt.

6. Verfahren nach einem der Ansprüche 1 bis 5, **dadurch gekennzeichnet, dass** der Vakuumbehandlungsprozess ein Magnetronsputterprozess ist und die vorgegebene Bewegung eine vorgegebene Bewegung des Magnetrontunnelmagnetfeldes bezüglich einer Targetsputterfläche umfasst.

7. Verfahren nach einem der Ansprüche 1 bis 6, **dadurch gekennzeichnet, dass** man mit Hilfe der Entladung einen Feststoff in die Behandlungsatmosphäre freisetzt, in die genannte Atmosphäre ein Reaktivgas einlässt und die Verteilung des Verbindungsverhältnisses zwischen Feststoff und Komponenten des Reaktivgases auf der Oberfläche als das Behandlungsresultat einstellt.

8. Verfahren nach einem der Ansprüche 1 bis 7, **dadurch gekennzeichnet, dass** man, vor Behandlungsende, ein Behandlungs-Zwischenresultat misst und mit einem Soll-Behandlungszwischenresultat vergleicht, in Funktion des Vergleichsresultates die vorgegebene Bewegung und/oder die zeitliche Änderung damit nachstellt.

9. Verfahren nach Anspruch 8, **dadurch gekennzeichnet, dass** die Messung des Behandlungszwischenresultates ohne Vakuumunterbrechung erfolgt.

10. Verfahren nach Anspruch 9, **dadurch gekennzeichnet, dass** die Messung in situ während der Substratbehandlung erfolgt und das Messresultat als gemessene Regelgrösse einem Regelkreis zugeführt wird, welcher die vorgegebene Relativbewegung und/oder die zeitliche Änderung als Stellgrösse für eine Behandlungsresultats-Regelung stellt.

11. Verwendung des Verfahrens nach einem der Ansprüche 1 bis 10 für die Herstellung von beschichteten Werkstücken mit vorgegebener räumlicher Verkippung der Schicht.

12. Verwendung des Verfahrens nach einem der Ansprüche 1 bis 11 für die Herstellung von Komponenten, welche auf der Basis akustischer Oberflächenwellen arbeiten (SAW) oder von "Bulk acoustic waves" (BAW).

## Claims

1. Method for production of a substrate with a surface treated by means of a vacuum process, namely by coating the substrate surface by means of a single source from which a single material is released from the solid phase, plasma-supported, into the process atmosphere or by plasma-supported removal of material from the substrate surface or by plasma-supported changing of material on the substrate surface, in which the surface has a pre-specified superficial distribution of the treatment result, wherein a plasma discharge is set with a locally non-homogenous density distribution, the substrate is exposed to the effect of the plasma discharge with non-homogenous density distribution, and a pre-specified periodic movement of the non-homogenous density distribution is created relative to the substrate that is stationary in relation to a vacuum recipient, in which furthermore a pre-specified periodic temporal change is produced in the electrical power which feeds the discharge and/or in a further electrical signal, where provided, that lays the substrate to bias, and that the said temporal change is synchronised with the pre-specified movement and the pre-specified surface distribution is achieved by setting the movement and the temporal change.

2. Method according to claim 1, **characterised in that** the plasma discharge is created with at least one area with a predominant density maximum.

3. Method according to one of claims 1 or 2, **characterised in that** the non-homogenous density distribution is at least co-generated by means of a magnetic field.

4. Method according to claim 3, **characterised in that** the magnetic field distribution is moved locally in the recipient in which the discharge is created.

5. Method according to any of claims I to 4, **characterised in that** the plasma discharge and/or bias application is generated by means of DC, AC, DC and overlaid AC.

6. Method according to any of claims 1 to 5, **characterised in that** the vacuum treatment process is a magnetron sputter process and the pre-specified movement comprises a pre-specified movement of the magnetron tunnel magnetic field in relation to a target sputter surface.

7. Method according to any of claims 1 to 6, **characterised in that** using the discharge a solid is released into the treatment atmosphere, a reactive gas is introduced into said atmosphere and the distribution of the connecting relationship between solid and components of the reactive gas on the surface is set as the treatment result.

8. Method according to any of claims 1 to 7, **characterised in that** before the treatment end a treatment intermediate result is measured and compared with a nominal treatment intermediate result, as a function of the comparison result the pre-specified movement and/or temporal change are adjusted accordingly.

9. Method according to claim 8, **characterised in that** the treatment intermediate result is measured without vacuum interruption.

10. Method according to claim 9, **characterised in that** measurement is performed in-situ during substrate treatment and the measurement result supplied as a measured control parameter to a control circuit which sets the pre-specified relative movement and/or temporal change as variables for a treatment result control.

11. Use of the method according to any of claims 1 to 10 for production of coated workpieces with pre-specified spatial tilting of the layer.

12. Use of the method according to any of claims 1 to 11 for production of components which work on the basis of surface acoustic waves (SAW) or bulk acoustic waves (BAW).

## Revendications

1. Procédé pour fabriquer un substrat présentant une surface traitée à l'aide d'un traitement sous vide, à savoir grâce au revêtement de la surface de substrat à l'aide d'une seule source à partir de laquelle une seule matière est libérée de la phase de corps solide vers l'atmosphère de traitement, avec utilisation d'un plasma, ou grâce à l'enlèvement de matière de la surface de substrat avec utilisation d'un plasma, ou grâce à la modification de matière sur la surface de substrat avec utilisation d'un plasma, selon lequel la surface a une répartition de surface du résultat de traitement qui est prédéfinie, étant précisé qu'on produit une décharge de plasma avec une répartition de densité localement non homogène, que le substrat est soumis à l'action de la décharge de plasma à répartition de densité non homogène et qu'on produit un déplacement périodique prédéfini de la répartition de densité non homogène, par rapport au substrat qui est stationnaire par rapport à un récipient à vide, selon lequel on produit une variation temporelle périodique prédéfinie de la puissance électrique qui alimente la décharge et/ou d'un signal électrique supplémentaire éventuellement prévu qui polarise le substrat, et selon lequel on synchronise ladite variation temporelle avec le mouvement prédéfini, et en réglant le déplacement et la variation temporelle on produit la répartition de surface prédéfinie.

2. Procédé selon la revendication 1, **caractérisé en ce que** la décharge de plasma est produite avec au moins une zone présentant un maximum de densité très net.

3. Procédé selon la revendication 1 ou 2, **caractérisé en ce qu'**on produit aussi au moins la répartition de densité non homogène à l'aide d'un champ magnétique.

4. Procédé selon la revendication 3, **caractérisé en ce qu'**on déplace la répartition de champ magnétique localement dans le récipient dans lequel la décharge est produite.

5. Procédé selon l'une des revendications 1 à 4, **caractérisé en ce qu'**on produit la décharge de plasma et/ou la polarisation à l'aide d'un courant continu, d'un courant alternatif, d'un courant continu et d'un courant alternatif superposé.

6. Procédé selon l'une des revendications 1 à 5, **caractérisé en ce que** le processus de traitement sous vide est un processus de pulvérisation cathodique par magnétron et le déplacement prédéfini comprend un déplacement prédéfini du champ magnétique de tunnel du magnétron par rapport à une surface cible de pulvérisation cathodique.

7. Procédé selon l'une des revendications 1 à 6, **caractérisé en ce que**, à l'aide de la décharge, on libère une matière solide dans l'atmosphère de traitement, on introduit dans ladite atmosphère un gaz réactif et on règle comme résultat de traitement la répartition du rapport de liaison entre la matière solide et les composants du gaz réactif sur la surface.

8. Procédé selon l'une des revendications 1 à 7, **caractérisé en ce qu'**on mesure avant la fin du traitement un résultat intermédiaire de traitement, on le compare à un résultat intermédiaire de traitement théorique et en fonction du résultat de la comparaison, on rajuste ainsi le déplacement prédéfini et/ou la variation dans le temps.

9. Procédé selon la revendication 8, **caractérisé en ce que** la mesure du résultat intermédiaire de traitement se fait sans interruption du vide.

10. Procédé selon la revendication 9, **caractérisé en ce que** la mesure se fait in situ pendant le traitement du substrat, et le résultat de mesure est transmis comme grandeur de réglage mesurée à un circuit de régulation qui règle le déplacement relatif prédéfini et/ou la variation dans le temps comme grandeur de réglage pour une régulation du résultat de traitement.

11. Utilisation du procédé selon l'une des revendications 1 à 10 pour la fabrication de pièces revêtues, avec un basculement spatial prédéfini de la couche.

12. Utilisation du procédé selon l'une des revendications 1 à 11 pour la fabrication de composants qui fonctionnent sur la base d'ondes acoustiques de surface (SAW) ou d'ondes acoustiques en volume ("Bulk acoustic waves", BAW).
